# EUROPÄISCHE PATENTSCHRIFT

(11) **EP 0 735 397 B1**
(45) Veröffentlichungstag und Bekanntmachung des Hinweises auf die Patenterteilung: **12.06.2002**
(21) Anmeldenummer: 96103557.3
(22) Anmeldetag: 06.03.1996
(51) Int. Cl.: G02B 27/14, H01S 5/40

(54) **Mikrooptische Vorrichtung zum Umformen von Strahlenbündeln einer Laserdiodenanordnung sowie Verfahren zur Herstellung dieser Vorrichtung**
Micro-optical device for transforming beams of a laser diode array and method for the production of such a device
Dispositif micro-optique pour transformer des faisceaux d'un arrangement de diodes laser et procédé de fabrication d'un tel dispositif

(30) Priorität: 29.03.1995 DE 19511593
(43) Veröffentlichungstag der Anmeldung: 02.10.1996
(73) Patentinhaber: Osram Opto Semiconductors GmbH & Co. OHG, 93049 Regensburg (DE)
(72) Erfinder: Späth, Werner, Dipl.-Phys., 83607 Holzkirchen (DE); Grötsch, Stefan, Dipl.-Ing. (FH), 93051 Regensburg (DE); Moser, Ralf, Dipl.-Ing. (FH), 93326 Abensberg (DE); Bogner, Georg, Dipl.-Phys., 93051 Regensburg (DE)
(74) Vertreter: Epping, Wilhelm, Dipl.-Ing.

(56) Entgegenhaltungen:
- US-A- 4 823 357
- US-A- 5 168 401
- US-A- 5 333 077
- US-A- 5 369 659
- LASER FOCUS WORLD, Bd. 30, Nr. 5, 1.Mai 1994, Seite 46, 48, 50 XP000447065 HOBBS J R: "OFFSET-PLANE MIRRORS TRANSFORM LASER BEAMS"

## Beschreibung

Die Erfindung bezieht sich auf eine mikrooptische Vorrichtung gemäß dem Oberbegriff des Patentanspruches 1.

Eine solche mikrooptische Vorrichtung ist beispielsweise aus J. R. Hobbs, "Diode pumped solid-state lasers: Offset-plane mirrors transform laserbeam", Laser Focus World, Mai 1994, S.47, bekannt. Die darin beschriebene mikrooptische Vorrichtung besteht aus zwei in einem Abstand parallel zueinander angeordneten hochreflektierenden Spiegeln. Die beiden Spiegel sind vertikal und horizontal gegeneinander versetzt. Das in einem Winkel α, mit 0°<α<190°, zur Spiegelflächennormalen einfallende erste Laserstrahlenbündel eines Laserdiodenbarrens wird mittels geeigneter mehrfacher Totalreflektion zwischen den beiden Spiegeln in das zweite Laserstrahlenbündel aus parallel nebeneinander angeordneten streifenförmigen Einzellaserstrahlen umgeformt. Eine wesentliche Schwierigkeit dieses Spiegelsystems besteht darin, daß zu einer effektiven Strahlenbündel-Umformung eine hochgenaue Justierung der beiden Spiegel zueinander und des Spiegelpaares zum einfallenden ersten Laserstrahlenbündel notwendig ist. Außerdem sind die Reflexionsverluste aufgrund der Mehrfachreflexion innerhalb des Spiegelpaares sehr hoch. Der maximal erzielte Umformwirkungsgrad liegt bei etwa 70%.

Aus der US 5,168,401 ist eine mikrooptische Vorrichtung bekannt, die den Einzellaserstrahlen eines Laserstrahlenbündels eines Laserdiodenarrays mittels einer Prismen- oder Spiegelanordnung eine Drehtransformation zuführt. In der US 5,369,659 ist ein optisches System beschrieben, bei dem mittels einer diffraktiven Optik ein Laserstrahlenbündel eines Laserdiodenarrays in eine optische Faser eingekoppelt wird.

Der Erfindung liegt daher die Aufgabe zugrunde, eine mikrooptische Vorrichtung der eingangs erwähnten Art zu entwickeln, die einfach zu justieren ist und deren Umformwirkungsgrad zwischen 90% und 100% liegt. Außerdem soll eine solche mikrooptische Vorrichtung kostengünstig herstellbar sein.

Diese Aufgabe wird durch eine mikrooptische Vorrichtung mit den Merkmalen des Anspruches 1, des Anspruches 2 oder des Anspruches 3 gelöst.

Diese mikrooptische Vorrichtung kann beispielsweise aus einem Halbleitermaterial bestehen, das für die Wellenlänge des vom Laserdiodenfeld abgestrahlten Laserlichtes durchlässig ist. Das Laserstrahlenbündel kann dann im Halbleitermaterial geführt werden, wodurch die Strahlaufweitung der Einzellaserstrahlen und damit auch der Strahlungsverlust vermindert werden kann. Die Strukturen der Strahlenparallelisierungsoptik und der Umlenkspiegelanordnung können mittels bekannter Ätztechniken der Halbleiterprozeßtechnik hergestellt werden. Dadurch ist eine kostengünstige Produktion der mikrooptischen Vorrichtung gewährleistet.

Weitere vorteilhafte Weiterbildungen sind Gegenstand der Unteransprüche 4 bis 11.

Die Erfindung wird anhand von vier Ausführungsbeispielen in Verbindung mit den Figuren 1 bis 6 näher erläutert. Es zeigen
- Figur 1: eine schematische perspektivische Darstellung eines ersten Ausführungsbeispieles einer erfindungsgemäßen mikrooptischen Vorrichtung,
- Figur 2: eine schematische Darstellung eines Ausschnitts eines Laserdiodenbarrens,
- Figur 3: eine schematische perspektivische Darstellung einer Umlenkspiegelanordnung eines zweiten Ausführungsbeispieles einer erfindungsgemäßen mikrooptischen Vorrichtung,
- Figur 4: eine schematische Darstellung der Strahlenbündel-Umformung mit einer mikrooptischen Vorrichtung gemäß Ausführungsbeispiel eins oder zwei,
- Figur 5: eine schematische perspektivische Darstellung einer Umlenkspiegelanordnung eines dritten Ausführungsbeispieles einer erfindungsgemäßen mikrooptischen Vorrichtung,
- Figur 6: eine schematische perspektivische Darstellung eines vierten Ausführungsbeispieles einer erfindungsgemäßen mikrooptischen Vorrichtung,
- Figur 7: eine schematische Darstellung der Strahlenbündel-Umformung mit einer mikrooptischen Vorrichtung gemäß Ausführungsbeispiel drei oder vier.

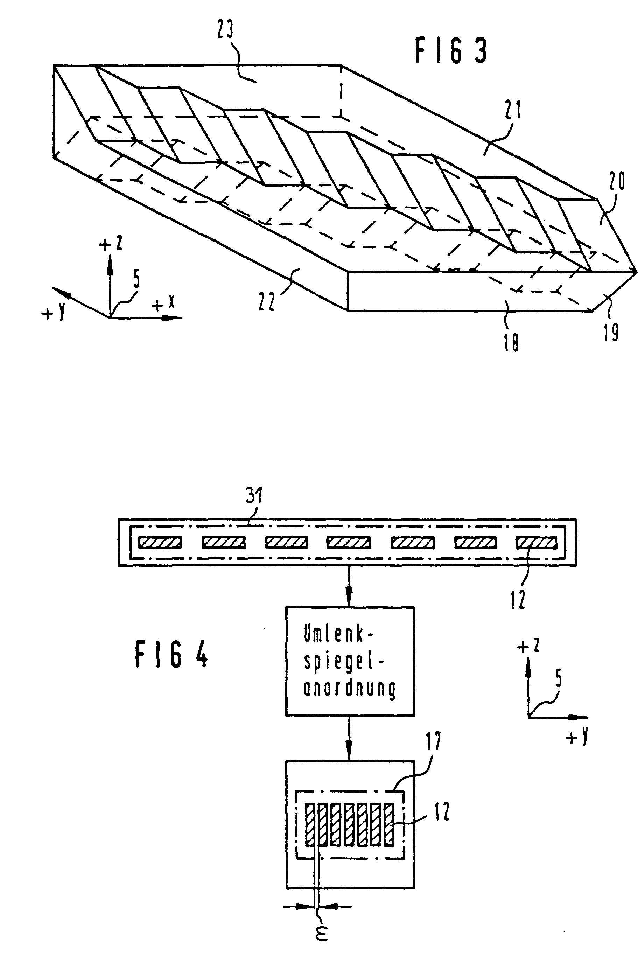

Die im nachfolgenden beschriebenen Ausführungsbeispiele dienen jeweils zur Umformung eines Laserstrahlenbündels 8, das von einem Laserdiodenbarren 6 gemäß Figur 2 abgestrahlt wird. Der Laserdiodenbarren 6 besteht aus sieben Einzellaserdioden 7. Die pn-Übergänge der Einzellaserdioden 7 liegen parallel zur x-y-Ebene eines orthogonalen Bezugssystems 5. Jede Einzellaserdiode 7 sendet einen Einzellaserstrahl 9 der Breite Δ y aus, der parallel zum pn-Übergang der Einzellaserdiode nur eine sehr schwache und senkrecht zum pn-Übergang eine starke Divergenz aufweist. Im folgenden wird jedoch aus Gründen der Einfachheit angenommen, daß die Einzellaserdioden 7 Einzellaserstrahlen 9 aussenden, die nur senkrecht zu den pn-Übergängen der Einzellaserdioden 7 divergent und parallel zu den pn-Übergängen parallel sind.

Anstelle des Laserdiodenbarrens 6 kann bei allen Ausführungsbeispielen selbstverständlicherweise auch eine Mehrzahl von Laserdiodenbarren oder eine Anzahl von einzelnen Laserdiodenchips verwendet sein.

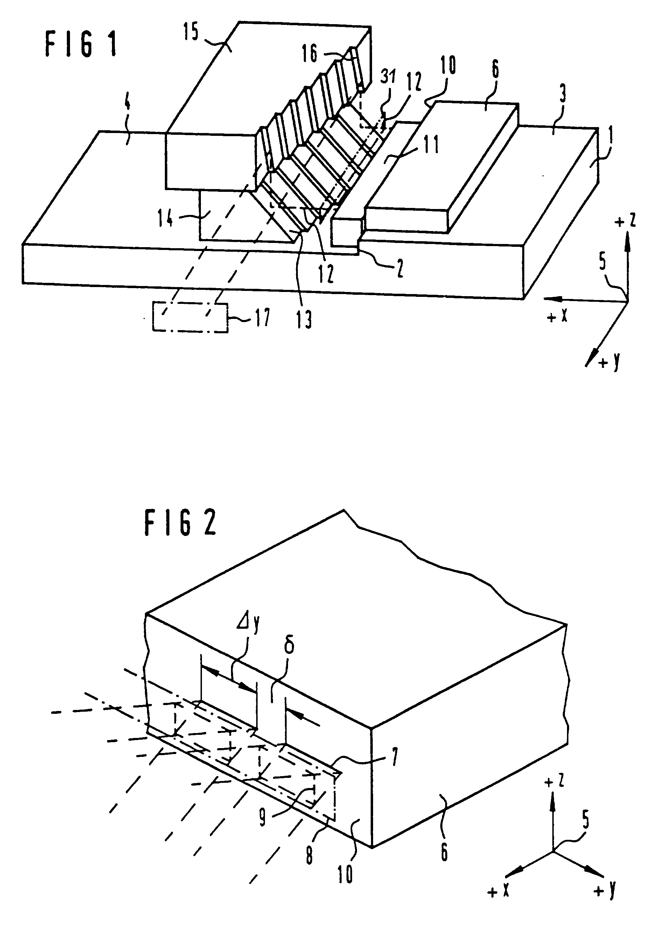

Das in Figur 1 schematisch dargestellte erste Ausführungsbeispiel einer erfindungsgemäßen mikrooptischen Vorrichtung ist auf einer Bodenplatte 1 aufgebaut. Die Bodenplatte 1 besteht beispielsweise aus einer Mo/Cu-Legierung oder einem anderen gut wärmeleitenden Material, dessen thermischer Ausdehnungskoeffizient den thermischen Ausdehnungskoeffizienten der anderen Komponenten der mikrooptischen Vorrichtung angepaßt ist. Die Oberseite der Bodenplatte 1 ist durch eine senkrechte Stufe 2 in zwei Flächen 3, 4 unterteilt, die parallel zur x-y-Ebene des orthogonalen Bezugssystems 5 liegen. Der Laserdiodenbarren 6 ist auf der höhergelegenen Fläche 3 beispielsweise mittels Löten oder Kleben befestigt, derart, daß die Laserlichtaustrittsfläche 10 des Laserdiodenbarrens 6 bündig mit der senkrechten Fläche der Stufe 2 abschließt. Die Einzellaserstrahlen 9 werden somit in x-Richtung abgestrahlt.

Eine plankonvexe Zylinderlinse 11 ist auf der tiefergelegenen Fläche 4 befestigt und grenzt mit ihrer gekrümmten Oberfläche an die Laserlichtaustrittsfläche 10 an. Sie kann aber auch in einem geringen Abstand zur Lichtaustrittsfläche 10 angeordnet sein, derart, daß sich die gekrümmte Oberfläche und die Lichtaustrittsfläche 10 gegenüberstehen. Die Zylinderlinse 11 ist beispielsweise aus Glas, Kunststoff oder aus einem für die Wellenlänge des Laserlichtes der Einzellaserdioden durchlässigen Halbleitermaterial hergestellt. Halbleitermaterialien eignen sich insbesondere aufgrund ihres großen Brechungsindex für diese Anwendung. Für Lichtwellenlängen λ > 400 nm kann beispielsweise SiC, für λ > 500 nm GaP, für λ > 900 nm GaAs und für λ > 1100 nm Si verwendet werden. Die Zylinderlinse 11 parallelisiert die in z-Richtung des Bezugssystems 5 stark divergenten Einzellaserstrahlen 9. Aus der Zylinderlinse 11 tritt somit ein Laserstrahlenbündel 31, bestehend aus sieben parallelisierten Einzellaserstrahlen 12 mit gleichem streifenförmigen Querschnitt aus. Die Querschnitts-Längsmittelachsen der Einzellaserstrahlen 12 liegen auf einer einzigen zur y-Achse des Bezugssystems 5 parallelen geraden Linie. In Figur 1 sind die randseitig angeordneten parallelisierten Einzellaserstrahlen 12 durch ihre Strahlachsen dargestellt.

Anstelle der Zylinderlinse 11 kann auch eine diffraktive Optik oder eine Kombination aus einer Zylinderlinse und einer diffraktiven Optik eingesetzt werden.

Auf der Fläche 4 ist in Strahlausbreitungsrichtung (+x-Richtung) nach der Zylinderlinse 11 eine aus sieben Einzelspiegeln 13 bestehende Spiegelreihe 14 befestigt. Sie ist beispielsweise aus Metall oder aus einem Halbleitermaterial hergestellt und die Spiegelflächen sind mit einem reflexionssteigernden Material wie beispielsweise Aluminium oder SiO₂/Si beispielsweise mittels Aufdampfen oder Sputtern beschichtet und/oder poliert. Die Spiegelflächennormalen der Einzelspiegel 13 bilden mit den Strahlachsen der parallelisierten Einzellaserstrahlen 12 einen Winkel von 45° und verlaufen parallel zur x-z-Ebene des Bezugssystems 5. Jeder Einzelspiegel 13 ist gegenüber seinen benachbarten Einzelspiegeln 13 in x-Richtung um Δz+ε parallelverschoben, so daß die Spiegelreihe 14 eine stufenförmige Struktur aufweist. Δz ist die Strahlhöhe in z-Richtung und ε ist bei exakt orthogonaler Abbildung der Einzellaserstrahlen 12 der in Figur 4 angegebene Abstand zwischen den streifenförmigen Einzellaserstrahlen 12 nach der Umformung des Laserstrahlenbündels 31 in das Laserstrahlenbündel 17. Die Breite und Länge der Spiegelflächen der Einzelspiegel 13 ist Δy+δ bzw. mindestens Δz/cos45°. Δy ist die Breite eines Einzellaserstrahles 9 nach Austritt aus dem Laserdiodenbarren 6 und δ ist der Abstand zwischen zwei Einzellaserstrahlen 9. Von der Spiegelreihe 14 werden die parallelisierten Einzellaserstrahlen 12 um 90° in z-Richtung umgelenkt und gleichzeitig in x-Richtung gegeneinander versetzt, derart, daß keine zwei Einzellaserstrahlen 12 mit ihrer Querschnitts-Längsmittelachse auf einer gemeinsamen geraden Linie liegen. Über der Spiegelreihe 14 ist eine weitere Spiegelreihe 15 mit sieben Einzelspiegeln 16 angeordnet. Die Spiegelreihe 15 ist beispielsweise genauso hergestellt wie die Spiegelreihe 14. Die Spiegelflächennormalen der Einzelspiegel 16 bilden mit den Strahlenachsen der um 90° in z-Richtung umgelenkten Einzellaserstrahlen 12 einen Winkel von 45° und verlaufen parallel zur y-z-Ebene des Bezugssystems 5. Jeder Einzelspiegel 16 ist gegenüber seinen benachbarten Einzelspiegeln 16 in y-Richtung um Δy+δ parallelverschoben, so daß die Spiegelreihe 15 eine stufenförmige Struktur aufweist. Die Breite und Länge der Spiegelflächen der Einzelspiegel 16 beträgt Δz+ε bzw. (Δy+δ)/cos45°. Die Einzelspiegel 13, 16 sind so zueinander angeordnet, daß die Mittelpunkte der Spiegelflächen von jeweils zwei Einzelspiegeln 13, 16 in z-Richtung genau übereinander liegen. Die Spiegelreihe 15 lenkt die von der Spiegelreihe 14 in z-Richtung umgelenkten Einzellaserstrahlen 12 um 90° in y-Richtung um und bildet die Einzellaserstrahlen 12 gemäß Figur 4 parallel nebeneinander ab.

Die in Figur 3 schematisch dargestellte Umlenkspiegelanordnung des zweiten Ausführungsbeispiels der erfindungsgemäßen mikrooptischen Vorrichtung besteht ebenfalls aus zwei Spiegelreihen 18, 21 aus jeweils sieben Einzelspiegel 19, 20. Die Anordnung und Größe der Einzelspiegel 19, 20 sowie die Anordnung der restlichen Komponenten der mikrooptischen Vorrichtung ist identisch dem ersten Ausführungsbeispiel. Der Unterschied zu den Spiegelreihen 14, 15 besteht darin, daß die Einzellaserstrahlen 12 nach der Zylinderlinse 11 nicht in Luft, sondern in einem für die Wellenlänge des von den Einzellaserdioden abgestrahlten Laserlichtes durchlässigen Medium geführt sind. Bei diesem Ausführungsbeispiel bilden somit die Grenzflächen zwischen dem lichtdurchlässigen Medium und Luft oder einem anderen angrenzenden Medium die Spiegelflächen der Einzelspiegel 19, 20 aus. Die Einzelspiegel 19, 20 sind beispielsweise von Ausnehmungen aus einem einzigen Quader, bestehend aus dem durchlässigen Medium, gebildet. Als Medium kann neben Glas und Kunststoff beispielsweise für eine Lichtwellenlänge λ > 400 nm auch SiC, für λ > 550 nm GaP, für λ > 900 nm GaAs und für λ > 1100 nm Si verwendet werden. Der Vorteil dieser Halbleitermaterialien besteht darin, daß aufgrund ihres hohen Brechungsindex keine Beschichtung der Spiegelflächen der Einzelspiegel 19, 20 erforderlich ist. Bei Verwendung von Glas können die Spiegelflächen zur Verbesserung der Reflexionseigenschaften beispielsweise mit Aluminium oder mit einem anderen geeigneten Material beschichtet werden. Als Beschichtungsverfahren kann Aufdampfen, Sputtern, CVD oder ein anderes aus der Halbleiterprozeßtechnik bekanntes Verfahren angewendet werden.

Bei dem Ausführungsbeispiel zwei treten die parallelen Einzelstrahlen 12 durch eine Lichteintrittsfläche 22 in die Spiegelreihe 18 ein und werden an den Einzelspiegeln 19 um 90° in z-Richtung umgelenkt und gleichzeitig in x-Richtung gegeneinander versetzt. Anschließend werden die Einzellaserstrahlen 12 von den Einzelspiegeln 20 um 90° in y-Richtung umgelenkt und treten durch eine Lichtaustrittsfläche 23 aus der Spiegelreihe 21 aus.

Figur 4 zeigt schematisch die Umformung des Laserstrahlenbündels 31 mittels der Umlenkspiegelanordnung gemäß Ausführungsbeispiel eins oder zwei. Das Laserstrahlenbündel 31 aus sieben parallelisierten Einzellaserstrahlen 12 wird in ein rechteckiges Laserstrahlenbündel 17 aus sieben im Abstand ε parallel nebeneinander angeordneten parallelisierten Einzellaserstrahlen 12 umgeformt.

Eine Vereinfachung der beiden oben beschriebenen Ausführungsbeispiele eins und zwei kann dadurch erzielt werden, daß die Spiegelreihe 14 bzw. 18 durch einen einzigen größeren Spiegel ersetzt wird. Dieser Spiegel muß so angebracht sein, daß seine Spiegelflächennormale mit der x-y-Ebene des Bezugssystems 5 einen Winkel von 45° und mit der x-z-Ebene einen Winkel γ > 0° einschließt. Die Breite des schrägen Spiegels ist (Länge des Laserdiodenbarrens 6)* cosγ und die Höhe des schrägen Spiegels ist mindestens Δz/cos45°. Die Spiegelreihe 15 bzw. 21 bleibt hinsichtlich der Struktur unverändert. Die Breite der Einzelspiegel 16 bzw. 20 ist jedoch (Δy+δ)* tanγ.

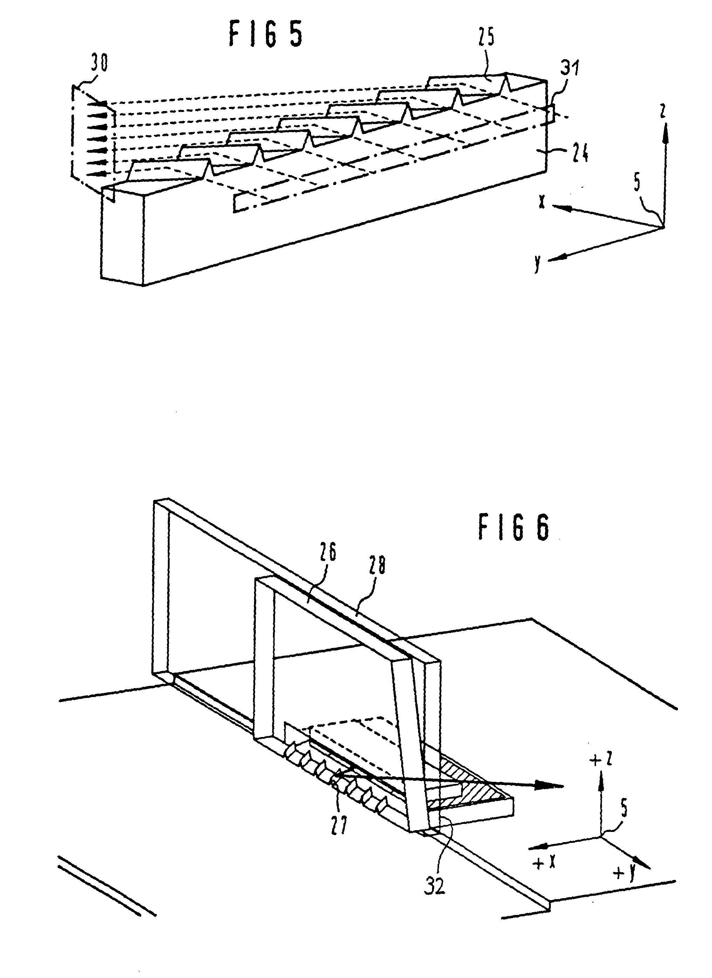

Das dritte Ausführungsbeispiel der erfindungsgemäßen mikrooptischen Vorrichtung weist anstelle von zwei Spiegelreihen, von denen jede eine 90°-Umlenkung durchführt, eine einzige Spiegelreihe 24 auf. Diese in Figur 5 dargestellte Spiegelreihe 24 besteht aus sieben Einzelspiegeln 25, deren Spiegelflächennormalen mit der x-z-Ebene des Bezugssystems 5 einen Winkel von 45° und mit der x-y-Ebene einen Winkel α > 0° aufweisen. Die Mittelpunkte der Spiegelflächen der Einzelspiegel 25 liegen auf einer einzigen parallel zur y-Achse des Bezugssystems 5 verlaufenden geraden Linie und haben voneinander einen Abstand von Δy+δ. Die Länge der Einzelspiegel 25 ist mindestens Δy/cos45° und die Breite mindestens Δz/cosα. Der Winkel α ist so gewählt, daß jeder parallelisierte Einzellaserstrahl 12 nach der Reflexion am zugehörigen Einzelspiegel 25 über den in +y-Richtung nachfolgenden Einzelspiegel 25 hinweg geführt ist. Um den Abstand η zwischen den abgebildeten Einzellaserstrahlen 29 so gering wie möglich zu gestalten, ist die Breite der Einzelspiegel 25 und der Winkel α so klein wie möglich zu wählen. Die Mindestgröße des Winkels α ist abhängig vom Abstand zwischen den Einzellaserdioden und von der Breite der Einzelspiegel 25.

Das in Figur 6 schematisch dargestellte vierte Ausführungsbeispiel einer erfindungsgemäßen mikrooptischen Vorrichtung ist im Prinzip dem dritten Ausführungsbeispiel identisch. Der Unterschied besteht darin, daß die Spiegelreihe 26 mit den Einzelspiegeln 27 so ausgebildet ist, daß die Einzellaserstrahlen 12 nicht in Luft, sondern in einem lichtleitenden Medium geführt sind. Das Medium ist für die Wellenlänge des von den Einzellaserdioden ausgestrahlten Laserlichtes durchlässig. Die Spiegelreihe 26 kann beispielsweise aus den bereits im zweiten Ausführungsbeispiel genannten Materialien hergestellt sein. Die Einzelspiegel 27 sind beispielsweise von keilförmigen Ausnehmungen aus einem Quader, bestehend aus dem für das Laserlicht der Einzellaserdioden durchlässigen Medium, gebildet. Die Spiegelflächen sind zur Verbesserung ihrer Reflexionseigenschaften beispielsweise mit Aluminium oder SiO₂/Si (evtl.Wechselschichten, d. h. abwechselnd SiO₂ und Si) beschichtet und/oder poliert. Die Spiegelreihe 26 ist mittels einer Koppelplatte 28, die ebenfalls aus einem für die Wellenlänge des Laserlichtes durchlässigen Material besteht, an die Zylinderlinse 11 gekoppelt. Die Spiegelreihe 26 und die Koppelplatte 28 können aber auch aus einem einzigen Teil bestehen. Ebenso kann anstelle der Koppelplatte 28 zwischen der Spiegelreihe 26 und dem Laserdiodenbarren eine Platte angeordnet sein, in der die Zylinderlinse 11 und/oder weitere Linsen eingebracht oder ausgebildet sind. Diese Platte kann aus einem Halbleitermaterial bestehen. Die Linse(n) können mittels herkömmlicher Halbleiterprozesse hergestellt sein.

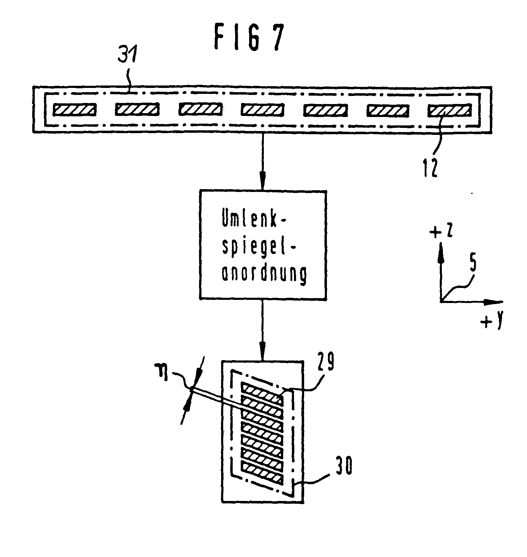

Figur 7 zeigt schematisch die Umformung des Laserstrahlenbündels 31 mittels der Umlenkspiegelanordnung gemäß Ausführungsbeispiel drei oder vier. Das Laserstrahlenbündel 31 aus sieben parallelisierten streifenförmigen Einzellaserstrahlen 12 wird in ein parallelogrammförmiges Laserstrahlenbündel 30 aus sieben im Abstand η parallel nebeneinander angeordneten parallelisierten streifenförmigen Einzellaserstrahlen 29 umgeformt.

An dieser Stelle sei nochmals darauf hingewiesen, daß die Einzellaserstrahlen 9 zum pn-Übergang der Einzellaserstrahlen nicht, wie oben angenommen, exakt parallel sondern schwach divergent sind. Die Spiegelabmessungen müssen daher entsprechend angepaßt werden. Die oben angegebenen Mindestmaße verändern sich zu größeren Werten hin. Das gleiche gilt, wenn die Einzellaserstrahlen 12 nicht exakt parallelisiert sondern schwach divergent sind. Für die Berechnung sind dann immer die Werte von Δy und Δz an den Spiegelflächen derjenigen Spiegel maßgebend, die in Strahlrichtung am weitesten von der Lichtaustrittsfläche 10 entfernt sind.

Die Führung der Einzellaserstrahlen 9, 12, 29 in einem optischen Medium hat den Vorteil, daß deren Aufweitung vermieden werden kann. In vorteilhafter Weise kann bei den Ausführungsbeispielen zwei und vier die Lichtaustrittsfläche 10 der Zylinderlinse 11 direkt an die Lichteintrittsfläche 22 bzw. 32 der Spiegelreihe 18 bzw. der Koppelplatte 28 angrenzen. Dadurch kann in der mikrooptischen Vorrichtung die Zahl der optischen Grenzflächen, die Reflexionsverluste verursachen, minimiert werden. Denkbar ist auch, daß die Spiegelreihen bzw. -reihe und die Zylinderlinse aus einem Teil gefertigt sind.

Die oben beschriebenen Spiegelanordnungen und die Zylinderlinse zeichnen sich in vorteilhafter Weise dadurch aus, daß sie mittels kostengünstiger Verfahren hergestellt werden können.

Plankonvexe Zylinderlinsen aus Halbleitermaterialien sind beispielsweise auf einem Wafer mittels bekannter Ätzverfahren herstellbar. Der Wafer wird dann in Einzellinsen geeigneter Länge und Breite aufgetrennt.

Die Spiegelreihen können beispielsweise mit Hilfe von in der Halbleiterprozeßtechnik bekannten Ätzverfahren aus Si, GaP, GaAs, SiC, Metall oder Glas hergestellt werden. Genauso können aber auch Spritz-, Press- und Gießverfahren für Kunststoff, Glas oder Metall eingesetzt werden. Zur Herstellung der Formen kann z. B. das sogenannte LIGA-Verfahren verwendet werden. Die Spiegelstrukturen können auch mittels mechanischer Verfahren wie beispielsweise das Mikropräzisions-Diamantdrehverfahren hergestellt werden. Auch eine Aneinanderreihung von strukturierten Glasscheiben durch anodisches Bonden, Löten oder Kleben ist möglich. Bei Kunststoffen kann die Spiegelstruktur durch mechanische Bearbeitung oder als Formspritzteil hergestellt werden.

An dieser Stelle sei vollständigkeitshalber noch erwähnt, daß, obwohl die in den Ausführungsbeispielen beschriebenen Umlenkspiegelanordnungen ausschließlich auf sieben Einzellaserstrahlen ausgelegt sind, die erfindungsgemäße mikrooptische Vorrichtung für jede beliebige Anzahl von Einzellaserstrahlen einsetzbar ist. Es muß lediglich jeweils die Anzahl der Einzelspiegel angepaßt sein.

## Patentansprüche

1. Mikrooptische Vorrichtung zum Umformen eines von einem oder mehreren Laserdiodenbarren oder einer Anzahl von einzelnen Laserdiodenchips in x-Richtung eines orthogonalen Bezugssystems (5) abgestrahlten ersten Laserstrahlenbündels (8), bestehend aus einer Mehrzahl von im Querschnitt streifenförmigen Einzellaserstrahlen (9), in ein zweites Laserstrahlenbündel (17,30), das parallel nebeneinander liegende parallelisierte Einzellaserstrahlen (12) aufweist, bei der eine Strahlenparallelisierungsoptik (11) die in z-Richtung des Bezugssystems (5) divergenten, im Querschnitt streifenförmigen Einzellaserstrahlen (9) des ersten Laserstrahlenbündels (8) parallelisiert und nachfolgend eine Umlenkspiegelanordnung das aus den parallelisierten streifenförmigen Einzellaserstrahlen (12) bestehende Laserstrahlenbündel (31) in das zweite Laserstrahlenbündel (17,30) umformt,
**dadurch gekennzeichnet, daß**
die Umlenkspiegelanordnung eine erste und eine zweite Spiegelreihe (14, 15) aufweist, daß die erste Spiegelreihe (14) die parallelisierten Einzellaserstrahlen (12) aus der x-Richtung ablenkt und gleichzeitig in x-Richtung gegeneinander versetzt, derart, daß die Längsmittelachsen der Querschnitte der parallelisierten Einzellaserstrahlen (12) auf in einem Abstand zueinander parallel verlaufenden Geraden liegen, und daß die zweite Spiegelreihe (15) die gegeneinander versetzten parallelisierten Einzellaserstrahlen (12) parallel nebeneinander abbildet.

2. Mikrooptische Vorrichtung zum Umformen eines von einem oder mehreren Laserdiodenbarren oder einer Anzahl von einzelnen Laserdiodenchips in x-Richtung eines orthogonalen Bezugssystems (5) abgestrahlten ersten Laserstrahlenbündels (8), bestehend aus einer Mehrzahl von im Querschnitt streifenförmigen Einzellaserstrahlen (9), in ein zweites Laserstrahlenbündel (17,30), das parallel nebeneinander liegende parallelisierte Einzellaserstrahlen (12) aufweist, bei der eine Strahlenparallelisierungsoptik (11) die in z-Richtung des Bezugssystems (5) divergenten, im Querschnitt streifenförmigen Einzellaserstrahlen (9) des ersten Laserstrahlenbündels (8) parallelisiert und nachfolgend eine Umlenkspiegelanordnung das aus den parallelisierten streifenförmigen Einzellaserstrahlen (12) bestehende Laserstrahlenbündel (31) in das zweite Laserstrahlenbündel (17,30) umformt,
**dadurch gekennzeichnet, daß**
die Umlenkspiegelanordnung einen schrägen Spiegel und eine Spiegelreihe aufweist, daß der schräge Spiegel eine Spiegelflächennormale aufweist, die mit der x-y-Ebene des Bezugssystems (5) einen Winkel von 45° und mit der x-z-Ebene des Bezugssystems (5) einen Winkel γ > 0° einschließt, daß die Breite des schrägen Spiegels gleich der Länge des Laserdiodenbarrens (6) * cosγ and die Höhe des schrägen Spiegels mindestens Δz/cos45° mit Δz = Strahlhöhe in z-Richtung ist, so daß der schräge Spiegel die parallelisierten Einzellaserstrahlen (12) aus der x-Richtung ablenkt und gleichzeitig in x-Richtung gegeneinander versetzt, und die Spiegelreihe die gegeneinander versetzten parallelisierten Einzellaserstrahlen (12) parallel nebeneinander abbildet, wobei die Breite der Einzelspiegel gleich (Δy+δ)* tanγ mit Δy = Breite eines Einzellaserstrahles nach Austritt aus dem Laserdiodenbarren; δ = Abstand zwischen zwei Einzellaserstrahlen; ist.

3. Mikrooptische Vorrichtung zum Umformen eines von einem oder mehreren Laserdiodenbarren oder einer Anzahl von einzelnen Laserdiodenchips in x-Richtung eines orthogonalen Bezugssystems (5) abgestrahlten ersten Laserstrahlenbündels (8), bestehend aus einer Mehrzahl von im Querschnitt streifenförmigen Einzellaserstrahlen (9), in ein zweites Laserstrahlenbündel (17,30), das parallel nebeneinander liegende parallelisierte Einzellaserstrahlen (12) aufweist, bei der eine Strahlenparallelisierungsoptik (11) die in z-Richtung des Bezugssystems (5) divergenten, im Querschnitt streifenförmigen Einzellaserstrahlen (9) des ersten Laserstrahlenbündels (8) parallelisiert und nachfolgend eine Umlenkspiegelanordnung das aus den parallelisierten streifenförmigen Einzellaserstrahlen (12) bestehende Laserstrahlenbündel (31) in das zweite Laserstrahlenbündel (17,30) umformt,
**dadurch gekennzeichnet, daß**
die Umlenkspiegelanordnung eine einzige Spiegelreihe (24) aufweist, die die parallelisierten Einzellaserstrahlen (12) aus der x-Richtung ablenkt, in z-Richtung gegeneinander versetzt und parallel nebeneinander abbildet.

4. Mikrooptische Vorrichtung nach Anspruch 3, **dadurch gekennzeichnet**, die Spiegelreihe (24) eine Mehrzahl von Einzelspiegeln (25) aufweist, daß die Spiegelflächennormalen der Einzelspiegel (25) mit der x-z-Ebene des Bezugssystems (5) einen Winkel von 45° und mit der x-y-Ebene des Bezugssystems (5) einen Winkel α > 0° aufweisen, daß die Mittelpunkte der Spiegelflächen der Einzelspiegel (25) auf einer einzigen parallel zur y-Achse des Bezugssystems (5) verlaufenden geraden Linie liegen und voneinander einen Abstand von Δy+δ, daß die Länge der Einzelspiegel (25) mindestens Δy/cos45° mit Δy = Breite eines Einzellaserstrahles nach Austritt aus dem Laserdiodenbarren; δ = Abstand zwischen zwei Einzellaserstrahlen; und die Breite der Einzelspiegel (25) mindestens Δz/cosα mit Δz = Strahlhöhe in z-Richtung ist und daß der Winkel α ist so gewählt, daß jeder parallelisierte Einzellaserstrahl (12) nach der Reflexion am zugehörigen Einzelspiegel (25) über den in +y-Richtung nachfolgenden Einzelspiegel (25) hinweg geführt ist.

5. Mikrooptische Vorrichtung nach einem der Ansprüche 1bis 4,
**dadurch gekennzeichnet, daß** die Längsmittelachsen der streifenförmigen Querschnitte der Einzellaserstrahlen (9) des ersten Laserstrahlenbündels (8) auf einer einzigen in y-Richtung des Bezugssystems (5) verlaufenden geraden Linie liegen.

6. Mikrooptische Vorrichtung nach einem der Ansprüche 1 bis 5, **dadurch gekennzeichnet, daß** das zweite Laserstrahlenbündel (17,30) eine Mehrzahl von parallel nebeneinander angeordneten im Querschnitt streifenförmigen Einzellaserstrahlen (12, 29) aufweist.

7. Mikrooptische Vorrichtung nach einem der Ansprüche 1 bis 6, **dadurch gekennzeichnet, daß** das aus parallelisierten streifenförmigen Einzellaserstrahlen (12) bestehende Laserstrahlenbündel (31) und/oder das zweite Laserstrahlenbündel (17,30) jeweils eine Mehrzahl von Einzellaserstrahlen (9 bzw. 12,29) mit jeweils gleichem Querschnitt aufweist.

8. Mikrooptische Vorrichtung nach einem der Ansprüche 1 bis 7, **dadurch gekennzeichnet, daß** die Strahlenparallelisierungsoptik eine Zylinderlinse (11) aufweist.

9. Mikrooptische Vorrichtung nach einem der Ansprüche 1 bis 8, **dadurch gekennzeichnet, daß** die Strahlenparallelisierungsoptik eine diffraktive Optik aufweist.

10. Mikrooptische Vorrichtung nach einem der Ansprüche 1 bis 9, **dadurch gekennzeichnet, daß** die Strahlenparallelisierungsoptik und die Umlenkspiegelanordnung aus einem Halbleitermaterial bestehen, das für die Wellenlänge des vom Laserdiodenbarren abgestrahlten Laserlichtes durchlässig ist, und daß die Laserstrahlen im Inneren des Halbleitermaterials geführt sind.

11. Verfahren zur Herstellung einer mikrooptischen Vorrichtung nach Anspruch 10, **dadurch gekennzeichnet, daß** die Strukturen der Strahlparallelisierungsoptik und der Umlenkspiegelanordnung mittels bekannten Ätztechniken der Halbleiterprozeßtechnik hergestellt werden.

## Claims

1. Microoptical device for converting into a second laser beam bundle (17, 30), which has parallelized individual laser beams (12) lying parallel next to one another, a first laser beam bundle (8) which is emitted by one or more laser diode strip structures or a number of individual laser diode chips in the x-direction of an orthogonal reference system (5) and comprises a plurality of individual laser beams (9) of strip-shaped cross section, in the case of which device a beam-parallelizing optical system (11) parallelizes the individual laser beams (9) of the first laser beam bundle (8), which are divergent in the z-direction of the reference system (5) and of strip-shaped cross section, and subsequently a deflecting mirror arrangement converts the laser beam bundle (31) comprising the parallelized strip-shaped individual laser beams (12) into the second laser beam bundle (17, 30), **characterized in that** the deflecting mirror arrangement has a first and a second row (14, 15) of mirrors, **in that** the first row (14) of mirrors deflects the parallelized individual laser beams (12) from the x-direction [sic] and simultaneously offsets them from one another in the x-direction in such a way that the longitudinal central axes of the cross sections of the parallelized individual laser beams (12) lie on straight lines extending parallel to one another at a spacing, and **in that** the second row (15) of mirrors images the mutually offset parallelized individual laser beams (12) in a fashion parallel next to one another.

2. Microoptical device for converting into a second laser beam bundle (17, 30), which has parallelized individual laser beams (12) lying parallel next to one another, a first laser beam bundle (8) which is emitted by one or more laser diode strip structures or a number of individual laser diode chips in the x-direction of an orthogonal reference system (5) and comprises a plurality of individual laser beams (9) of strip-shaped cross section, in the case of which device a beam-parallelizing optical system (11) parallelizes the individual laser beams (9) of the first laser beam bundle (8), which are divergent in the z-direction of the reference system (5) and of strip-shaped cross section, and subsequently a deflecting mirror arrangement converts the laser beam bundle (31) comprising the parallelized strip-shaped individual laser beams (12) into the second laser beam bundle (17, 30), **characterized in that** the deflecting mirror arrangement has an oblique mirror and a row of mirrors, **in that** the oblique mirror has a mirror surface normal which encloses an angle of 45° with the x-y plane of the reference system (5) and an angle γ > 0° with the x-z plane of the reference system (5), **in that** the width of the oblique mirror is equal to the length of the laser diode strip structure (6) * cosγ, and the height of the oblique mirror is at least Δz/cos45°, where Δz = beam height in the z-direction, such that the oblique mirror deflects the parallelized individual laser beams (12) from the x-direction and simultaneously offsets them from one another in the x-direction [sic], and the row of mirrors images the mutually offset parallelized individual laser beams (12) in a fashion parallel next to one another, the width of the individual mirrors being equal to (Δy+δ)* tanγ, where Δy = width of an individual laser beam after exiting from the laser diode strip structure; δ = spacing between two individual laser beams.

3. Microoptical device for converting into a second laser beam bundle (17, 30), which has parallelized individual laser beams (12) lying parallel next to one another, a first laser beam bundle (8) which is emitted by one or more laser diode strip structures or a number of individual laser diode chips in the x-direction of an orthogonal reference system (5) and comprises a plurality of individual laser beams (9) of strip-shaped cross section, in the case of which device a beam-parallelizing optical system (11) parallelizes the individual laser beams (9) of the first laser beam bundle (8), which are divergent in the z-direction of the reference system (5) and of strip-shaped cross section, and subsequently a deflecting mirror arrangement converts the laser beam bundle (31) comprising the parallelized strip-shaped individual laser beams (12) into the second laser beam bundle (17, 30), **characterized in that** the deflecting mirror arrangement has a single row (24) of mirrors which deflects the parallelized individual laser beams (12) from the x-direction, offsets them from one another in the z-direction and images them in a fashion parallel next to one another.

4. Microoptical device according to Claim 3, **characterized in that** the row (24) of mirrors has a plurality of individual mirrors (25), **in that** the mirror surface normals of the individual mirrors (25) have [sic] an angle of 45° with the x-z plane of the reference system (5) and an angle α > 0° with the x-y plane of the reference system (5), **in that** the centre points of the mirror surfaces of the individual mirrors (25) lie on a single straight line extending parallel to the y-axis of the reference system (5), and are at a spacing of Δy+δ from one another, **in that** the length of the individual mirrors (25) is at least Δy/cos45°, where Δy = width of an individual laser beam after exiting from the laser diode strip structure; δ = spacing between two individual laser beams; and the width of the individual mirrors (25) is at least Δz/cosα, where Δz = beam height in the z-direction, and **in that** the angle α is selected such that, after reflection at the associated individual mirror (25), each parallelized individual laser beam (12) is guided away via the individual mirror (25) which is downstream in the +y-direction.

5. Microoptical device according to one of Claims 1 to 4, **characterized in that** the longitudinal central axes of the strip-shaped cross sections of the individual laser beams (9) of the first laser beam bundle (8) lie on a single straight line extending in the y-direction of the reference system (5).

6. Microoptical device according to one of Claims 1 to 5, **characterized in that** the second laser beam bundle (17, 30) has a plurality of individual laser beams (12, 29) of strip-shaped cross section arranged in a fashion parallel next to one another.

7. Microoptical device according to one of Claims 1 to 6, **characterized in that** the laser beam bundle (31) comprising parallelized strip-shaped individual laser beams (12), and/or the second laser beam bundle (17, 30) in each case has a plurality of individual laser beams (9 or 12, 29) each having the same cross section.

8. Microoptical device according to one of Claims 1 to 7, **characterized in that** the beam-parallelizing optical system has a cylindrical lens (11).

9. Microoptical device according to one of Claims 1 to 8, **characterized in that** the beam-parallelizing optical system has a diffractive optical system.

10. Microoptical device according to one of Claims 1 to 9, **characterized in that** the beam-parallelizing optical system and the deflecting mirror arrangement consist of a semiconductor material which is transparent to the wavelength of the laser light emitted by the laser diode strip structure, and **in that** the laser beams are guided in the interior of the semiconductor material.

11. Method for producing a microoptical device according to Claim 10, **characterized in that** the structures of the beam-parallelizing optical system and of the deflecting mirror arrangement are produced by means of etching techniques known in semiconductor process engineering.

## Revendications

1. Dispositif micro-optique pour la transformation d'un premier faisceau de rayons lasers (8), qui est émis par une ou plusieurs barres de diodes lasers ou par un certain nombre de puces à diodes lasers individuelles dans la direction x d'un système de référence (5) orthogonal et qui est constitué d'une multiplicité de rayons lasers individuels (9) en forme de bandes en section transversale, en un deuxième faisceau de rayons lasers (17, 30), qui comporte des rayons lasers individuels (12) parallélisés et disposés parallèlement les uns à côté des autres, dans lequel une optique de parallélisation de rayons (11) parallélise les rayons lasers individuels (9), divergents dans la direction z du système de référence (5) et en forme de bandes en section transversale, du premier faisceau de rayons lasers (8) puis un dispositif à miroirs de déviation transforme le faisceau de rayons lasers (31) constitué des rayons lasers individuels parallélisés en forme de bandes (12) en deuxième faisceau de rayons lasers (17, 30),
**caractérisé par le fait que**
le dispositif à miroirs de déviation comporte une première et une deuxième série de miroirs (14, 15), la première série de miroirs (14) dévie les rayons lasers individuels parallélisés (12) hors de la direction x et les décale en même temps les uns par rapport aux autres dans la direction x de telle sorte que les axes médians longitudinaux des sections transversales des rayons lasers individuels parallélisés (12) sont sur des droites qui s'étendent parallèlement à une certaine distance les unes des autres et la deuxième série de miroirs (15) projette les rayons lasers individuels parallélisés et décalés les uns par rapport aux autres (12) parallèlement les uns à côté des autres.

2. Dispositif micro-optique pour la transformation d'un premier faisceau de rayons lasers (8), qui est émis par une ou plusieurs barres de diodes lasers ou par un certain nombre de puces à diodes lasers individuelles dans la direction x d'un système de référence (5) orthogonal et qui est constitué d'une multiplicité de rayons lasers individuels (9) en forme de bandes en section transversale, en un deuxième faisceau de rayons lasers (17, 30), qui comporte des rayons lasers individuels (12) parallélisés et disposés parallèlement les uns à côté des autres, dans lequel une optique de parallélisation de rayons (11) parallélise les rayons lasers individuels (9), divergents dans la direction z du système de référence (5) et en forme de bandes en section transversale, du premier faisceau de rayons lasers (8) puis un dispositif à miroirs de déviation transforme le faisceau de rayons lasers (31) constitué des rayons lasers individuels parallélisés en forme de bandes (12) en deuxième faisceau de rayons lasers (17, 30),
**caractérisé par le fait que**
le dispositif à miroirs de déviation comporte un miroir incliné et une série de miroirs, le miroir incliné comporte une normale à la surface de miroir qui fait un angle de 45° avec le plan x-y du système de référence (5) et un angle γ > 0° avec le plan x-z du système de référence (5), la largeur du miroir incliné est égale à la longueur de la barre de diodes lasers (6) multipliée par cosγ et la hauteur du miroir incliné est égale à au moins Δz / cos45°, avec Δz = hauteur de rayon dans la direction z, de telle sorte que le miroir incliné dévie les rayons lasers individuels parallélisés (12) hors de la direction x et les décale en même temps les uns par rapport aux autres dans la direction x et que la série de miroirs projette les rayons lasers individuels parallélisés et décalés les uns par rapport aux autres (12) parallèlement les uns à côté des autres, la largeur des miroirs individuels étant égale à (Δy + δ) * tanγ, avec Δy = largeur d'un rayon laser individuel après la sortie de la barre de diodes lasers et δ = distance entre deux rayons lasers individuels.

3. Dispositif micro-optique pour la transformation d'un premier faisceau de rayons lasers (8), qui est émis par une ou plusieurs barres de diodes lasers ou par un certain nombre de puces à diodes lasers individuelles dans la direction x d'un système de référence (5) orthogonal et qui est constitué d'une multiplicité de rayons lasers individuels (9) en forme de bandes en section transversale, en un deuxième faisceau de rayons lasers (17, 30), qui comporte des rayons lasers individuels (12) parallélisés et disposés parallèlement les uns à côté des autres, dans lequel une optique de parallélisation de rayons (11) parallélise les rayons lasers individuels (9), divergents dans la direction z du système de référence (5) et en forme de bandes en section transversale, du premier faisceau de rayons lasers (8) puis un dispositif à miroirs de déviation transforme le faisceau de rayons lasers (31) constitué des rayons lasers individuels parallélisés en forme de bandes (12) en deuxième faisceau de rayons lasers (17, 30),
**caractérisé par le fait que**
le dispositif à miroirs de déviation comporte une seule série de miroirs (24) qui dévie les rayons lasers individuels parallélisés (12) hors de la direction x, qui les décale les uns par rapport aux autres dans la direction z et qui les projette parallèlement les uns à côté des autres.

4. Dispositif micro-optique selon la revendication 3, **caractérisé par le fait que** la série de miroirs (24) comporte une multiplicité de miroirs individuels (25), les normales aux surfaces des miroirs individuels (25) forment un angle de 45° avec le plan x-z du système de référence (5) et un angle α > 0° avec le plan x-y du système de référence (5), les centres des surfaces des miroirs individuels (25) sont sur une seule ligne droite s'étendant parallèlement à l'axe y du système de référence (5) et sont écartés les uns des autres d'une distance Δy + δ, la longueur des miroirs individuels (25) vaut au moins Δy / cos45°, avec Δy = largeur d'un rayon laser individuel après la sortie de la barre de diodes lasers et δ = distance entre deux rayons lasers individuels ; et la largeur des miroirs individuels (25) au moins Δz / cosα, avec Δz = hauteur de rayon dans la direction z, et l'angle α est choisi de telle sorte que chaque rayon laser individuel parallélisé (12) après la réflexion sur le miroir individuel (25) associé est guidé au-dessus du miroir individuel (25) suivant dans la direction + y.

5. Dispositif micro-optique selon l'une des revendications 1 à 4, **caractérisé par le fait que** les axes médians longitudinaux des sections transversales en forme de bandes des rayons lasers individuels (9) du premier faisceau de rayons lasers (8) sont sur une seule ligne droite s'étendant dans la direction y du système de référence (5).

6. Dispositif micro-optique selon l'une des revendications 1 à 5, **caractérisé par le fait que** le deuxième faisceau de rayons lasers (17, 30) comporte une multiplicité de rayons lasers individuels (12, 29) en forme de bandes en section transversale et disposés parallèlement les uns à côté des autres.

7. Dispositif micro-optique selon l'une des revendications 1 à 6, **caractérisé par le fait que** le faisceau de rayons lasers (31) constitué de rayons lasers individuels (12) parallélisés et en forme de bandes et/ou le deuxième faisceau de rayons lasers (17, 30) comportent chacun une multiplicité de rayons lasers individuels (9 ou 12, 29) ayant chacun la même section transversale.

8. Dispositif micro-optique selon l'une des revendications 1 à 7, **caractérisé par le fait que** l'optique de parallélisation de rayons comporte une lentille cylindrique (11).

9. Dispositif micro-optique selon l'une des revendications 1 à 8, **caractérisé par le fait que** l'optique de parallélisation de rayons comporte une optique de diffraction.

10. Dispositif micro-optique selon l'une des revendications 1 à 9, **caractérisé par le fait que** l'optique de parallélisation de rayons et le dispositif à miroirs de déviation sont constitués en un matériau semi-conducteur qui est transparent pour la longueur d'onde de la lumière laser émise par la barre de diodes lasers et que les rayons lasers sont guidés à l'intérieur du matériau semi-conducteur.

11. Procédé de fabrication d'un dispositif micro-optique selon la revendication 10, **caractérisé par le fait qu'**on fabrique les structures de l'optique de parallélisation de rayons et du dispositif à miroirs de déviation au moyen de techniques de gravure connues de la technique des processus à semi-conducteurs.
